# EUROPEAN PATENT SPECIFICATION

(11) **EP 3 244 443 B1**
(45) Date of publication and mention of the grant of the patent: **23.06.2021**
(21) Application number: 17000764.5
(22) Date of filing: 03.05.2017
(51) Int. Cl.: C09D 183/04, H01L 21/02, H01L 21/66, H01L 21/33, H01L 21/683, H01L 23/31

(54) **WAFER PROCESSING LAMINATE, METHOD FOR MANUFACTURING THEREOF, AND METHOD FOR CHECKING COVERAGE OF ORGANIC FILM ON WAFER**
WAFERVERARBEITUNGSLAMINAT, HERSTELLUNGSVERFAHREN DAFÜR UND VERFAHREN ZUR ÜBERPRÜFUNG DER ABDECKUNG EINER ORGANISCHEN SCHICHT AUF EINEM WAFER
LAMINÉ DE TRAITEMENT DE PLAQUETTE, SON PROCÉDÉ DE FABRICATION ET PROCÉDÉ DE CONTRÔLE DE COUVERTURE DE FILM ORGANIQUE SUR UNE PLAQUETTE

(30) Priority: 12.05.2016 JP 2016095854
(43) Date of publication of application: 15.11.2017
(73) Proprietor: Shin-Etsu Chemical Co., Ltd., Chiyoda-ku, Tokyo (JP)
(72) Inventor: Tagami, Shohei, Annaka-shi, Gunma-ken (JP); Sugo, Michihiro, Annaka-shi, Gunma-ken (JP)
(74) Representative: Wibbelmann, Jobst

(56) References cited:
- EP-A1- 2 496 061
- EP-A1- 2 574 156
- US-A1- 2006 097 394
- US-B2- 9 070 393

## Description

### TECHNICAL FIELD

The present invention relates to a wafer processing laminate and a method for manufacturing thereof as well as a method for checking coverage of an organic film on a wafer.

### BACKGROUND ART

In circuit forming of semiconductor device wafers, the circuit line widths have been continuously miniaturized until now. As a result, wiring of the ten nano meter range comes to be formed. In photoresist materials used for forming the wiring, the coating films also have been shifted to thinner films. For measuring the film thicknesses of these photoresist materials, optical film thickness measuring apparatuses such as an ellipsometer have been used. These methods can be used for measuring a film thickness applied onto a silicon wafer with high flatness. However, it has been difficult to check the state of a thin film formed on a surface having unevenness in which a circuit has been already formed, or a surface having another organic film as an underlayment.

In case of material for rewiring used for a step of rewiring to additionally form wiring onto a wafer having an uneven surface on which a circuit is formed and/or an organic film as an underlayment, and a temporary adhesive material used for a step of grinding the back surface of a circuit-formed device wafer and a step of forming wiring in the back surface of the circuit-forming surface in order to use through silicon via (TSV) for three-dimensional mounting of a semiconductor (see Patent Literature 1, for example), the state of the film forming can be checked by observation of the cross section, etc. since the film thickness is thicker than photoresist material and so on for forming a circuit.

However, in case of forming a thin film with the thickness of less than 100 nm onto a wafer having an uneven surface on which a circuit is formed and/or an organic film as an underlayment, there has been no method to check the coverage conveniently by a nondestructive process to manufacture a thin film wafer.

### CITATION LIST

### PATENT LITERATURE

Patent Literature 1: Japanese Unexamined Patent Application Publication (Kokai) No. 2013-4821;
Patent Literature 2: European Patent Application EP 2 574 156 A, which discloses a wiring method and structure having wiring provided on surface.

### SUMMARY OF INVENTION

### TECHNICAL PROBLEM

The present invention was accomplished in view of the above-described problems. It is an object of the present invention to provide a wafer processing laminate in which the coverage of the thin film can be checked by a nondestructive and convenient method, with the wafer being reusable, even when the thin film with a film thickness of less than 100 nm is formed onto a wafer having an uneven surface on which a circuit is formed and/or an organic film as an underlayment; the manufacturing method thereof; and a method for checking coverage of the organic film on a wafer.

### SOLUTION TO PROBLEM

To accomplish the foregoing objects, the present invention provides a wafer processing laminate comprising a wafer having a surface on which unevenness and/or a protective organic film layer (A) is formed, and an organic film layer (B) with a film thickness of less than 100 nm formed on the wafer,
the organic film layer (B) comprising a fluorescent agent that emits visible light by irradiation with ultraviolet light.

In such a wafer processing laminate, when the wafer having the organic film layer (B) formed thereon is irradiated with ultraviolet light, it is possible to check the coverage of the organic film layer (B) on the basis of the emission state in the irradiation. This makes it possible to check the coverage of an organic film layer (B) with a film thickness of less than 100 nm formed on any wafers having a surface on which unevenness is formed (unevenness-forming surface), a surface on which a protective organic film layer (A) is formed (protective organic film layer (A)-forming surface), or a surface on which both of them are formed, by the convenient method in which the emission is checked without destructing the wafer, with the wafer being reusable.

The wafer having a surface on which unevenness and/or a protective organic film layer (A) is formed may be a device wafer having a circuit formed.

The device wafers described above are generally expensive, and the check method is desired to be nondestructive and convenient, with the wafer being reusable. Accordingly, it is more favorable to adopt the inventive wafer processing laminate.

The organic film layer (B) with a film thickness of less than 100 nm may be a spin-coated film.

The spin-coated film is a film formed by a spin-coating method. On a surface having unevenness, the spin-coating method particularly tends to form coating irregularities around the unevenness, and can have portions without forming the film in a very thin film thickness of less than 100 nm. The inventive wafer processing laminate can be favorably used for a purpose of checking such coating irregularities and coating failure.

The organic film layer (B) preferably has a film thickness of 5 to 50 nm.

When the film thickness is 100 nm or more, it is possible to check visually under a visible light since an interference fringe generates. When the film thickness is less than 100 nm, particularly 50 nm or less, however, it becomes difficult to check visually under a visible light, and the inventive wafer processing laminate can be more favorably used thereby.

The organic film layer (B) may comprise a thermoplastic organopolysiloxane polymer as a component other than the fluorescent agent.

The thermoplastic organopolysiloxane polymer, in particular, has low glass transition temperature and fluidity at the normal temperature, whereby it is difficult to check the coverage of the organic film by observing the cross section of a divided wafer. Accordingly, the inventive wafer processing laminate can be favorably applied when the thermoplastic organopolysiloxane polymer is used.

It is also preferable that the fluorescent agent be a fluorescent whitening agent.

When the fluorescent agent is a fluorescent whitening agent, it is easy to check the emission. It becomes more favorable to use the inventive wafer processing laminate.

The present invention also provides a method for checking coverage of an organic film layer (B) with a film thickness of less than 100 nm, being formed on a wafer having a surface on which unevenness and/or a protective organic film layer (A) is formed, characterized in that:
the organic film layer (B) comprises a fluorescent agent that emits visible light by irradiation with ultraviolet light, and
the wafer having the organic film layer (B) formed thereon is subjected to irradiation with ultraviolet light to check the coverage of the organic film layer (B) by an emission state in the irradiation.

Such a method for checking coverage of an organic film makes it possible to check the coverage of an organic film by a nondestructive and convenient process that can reuse the wafer.

The present invention further provides a method for manufacturing a wafer processing laminate, including the step of forming an organic film layer (B) with a film thickness of less than 100 nm onto a wafer having a surface on which unevenness and/or a protective organic film layer (A) is formed, characterized in that:
the organic film layer (B) comprises a fluorescent agent that emits visible light by irradiation with ultraviolet light.

Such a method for manufacturing a wafer processing laminate makes it possible to securely produce a wafer processing laminate in which the coverage of the organic film can be checked by a nondestructive and convenient method that can reuse the wafer.

It is preferable that the method further comprise the step of subjecting the wafer having the organic film layer (B) formed thereon to irradiation with ultraviolet light after the step of forming to check the coverage of the organic film layer (B) by an emission state in the irradiation.

Such a step for checking makes it more convenient to recognize a portion where the organic film layer (B) is not formed.

### ADVANTAGEOUS EFFECTS OF INVENTION

In the inventive wafer processing laminate, by irradiating the wafer having the organic film layer (B) formed thereon with ultraviolet light, it is possible to check the coverage of the organic film layer (B) on the basis of the emission state in the irradiation. This makes it possible to check the coverage of an organic film layer (B) with a film thickness of less than 100 nm formed on any wafers having an unevenness-forming surface, a protective organic film layer (A)-forming surface, or a surface on which both of them are formed, by the convenient method in which the emission is checked without destructing the wafer, with the wafer being reusable.

### BRIEF DESCRIPTION OF DRAWINGS

FIG. 1 is a schematic cross sectional view showing an example of a wafer processing laminate of the present invention;
FIG. 2 is a schematic cross sectional view showing a bare Si wafer having an organic film layer (B) formed thereon.

### DESCRIPTION OF EMBODIMENTS

Hereinafter, the present invention will be specifically described.

As described above, it has been demanded a wafer processing laminate in which the coverage of the organic film can be checked by a nondestructive and convenient method that can reuse the wafer, when an organic film layer (B) with a film thickness of less than 100 nm is formed on any wafers having an unevenness-forming surface, a protective organic film layer (A)-forming surface, or a surface on which both of them are formed.

The present inventors have diligently studied to accomplish the foregoing objects. As a result, the present inventors have found that the coverage of an organic film layer (B) can be checked when the organic film layer (B) with a film thickness of less than 100 nm is formed on any wafer, the surface of which has unevenness, a protective organic film layer (A), or both of them, by formulating a fluorescent agent that emits visible light by irradiating the organic film layer (B) with ultraviolet light, and by observing the visible light emitted by irradiating the ultraviolet light; thereby brought the present invention to completion.

Hereinafter, the embodiments of the present invention will be specifically described with referring to FIGS., but the present invention is not limited thereto.

### [Wafer Processing Laminate]

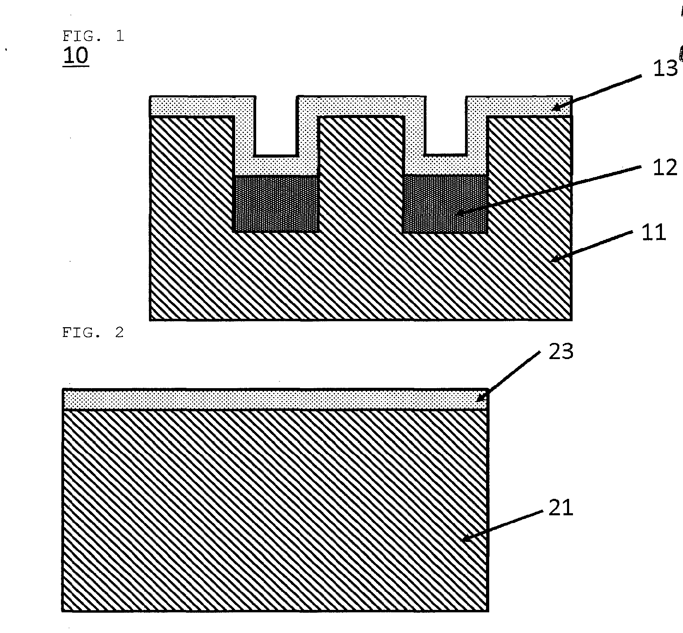

FIG. 1 is a schematic cross sectional view showing an example of a wafer processing laminate of the present invention. As shown in FIG. 1, in the inventive wafer processing laminate 10, the organic film layer (B) 13 with a film thickness of less than 100 nm is formed on the wafer 11 having a surface on which unevenness and the protective organic film layer (A) 12 are formed. This organic film layer (B) 13 contains a fluorescent agent that emits visible light by irradiation with ultraviolet light. Although FIG. 1 shows the wafer having a surface on which unevenness and a protective organic film layer (A) are formed, it is to be noted that the wafer in the present invention may have a surface on which unevenness or a protective organic film layer (A) is formed.

In such a wafer processing laminate, it is possible to check the state of forming the organic film layer (B) formed on the wafer on the basis of a difference between the emitted portions and portions without emission by applying ultraviolet light (200 to 400 nm, preferably 300 to 400 nm) and checking emitted visible light.

Hereinafter, each component of the inventive wafer processing laminate will be specifically described.

Illustrative examples of a wafer in the present invention include:
(a) a wafer having a surface on which unevenness is formed,
(b) a wafer having a surface on which a protective organic film layer (A) is formed, and
(c) a wafer having a surface on which both of the unevenness and a protective organic film layer (A) are formed.

The unevenness (fine ruggedness) formed on a wafer is not particularly limited in its shape. In general, however, illustrative examples thereof include a spherical, columnar, and polygonal prism structure having a difference of altitude of 0.1 to 500 µm and a size within a 1 to 1000 µm square, as well as a linear structure having a width of 0.1 to 1000 µm. When the film is formed on the wafer, such a structure can generate thickness variation of a formed film and coating failure at a portion having a difference of altitude. At a portion having a difference of altitude, reflected light is not normally returned, whereby the film thickness cannot be measured in some cases by an optical film thickness measuring apparatus, which is generally used for measuring a film thickness. It is also impossible to measure coating failure precisely when the coating failure portion is smaller than the diameter of the measuring spot.

In visual inspection, a wafer surface having a protective organic film layer (A) formed thereon shows small change when an organic film layer (B) is formed thereon. Accordingly, it is difficult to distinguish coating failure and coating irregularity. Such a change can be detected by using an optical film thickness measuring apparatus in the diameter of the measuring spot, but the problem portions are difficult to find over an entire wafer.

The protective organic film layer (A) is not particularly limited as far as it is a film formed for protecting a wafer surface. In general, thermosetting material is used, including polyimide, polybenzoxazole, silicone modified polymers, silicone polymers, acrylic polymers, epoxy polymers, and organic films containing silica filler. They may be photosensitive, and in that case, unevenness shape is generally formed at the same time.

The thickness of the protective organic film layer (A) is not particularly limited. The film thickness is generally 1 to 200 µm, preferably 2 to 100 µm, more preferably 5 to 50 µm.

These wafers may be a device wafer having a circuit (an electronic circuit) formed in the interior thereof or under the surface structure thereof. Such device wafers are generally expensive, and is desired to be inspected in a nondestructive process thereby.

In the inventive wafer processing laminate, the organic film layer (B) contains a fluorescent agent that emits visible light by irradiation with ultraviolet light. Accordingly, it is possible to irradiate the wafer having the organic film layer (B) formed thereon with ultraviolet light to check the coverage of the organic film layer (B) on the basis of an emission state in the irradiation. Therefore, even in the case of such wafers as described above, the present invention makes it possible to observe the situation around the portion having unevenness and the distribution state of the organic film layer (B) in the wafer surface by a nondestructive and convenient process.

### [Organic Film Layer (B)]

The organic film layer (B) is an organic film layer with a film thickness of less than 100 nm which contains a fluorescent agent that emits visible light by irradiation with ultraviolet light. The lower limit of the film thickness of the organic film layer (B) can be 1 nm, for example. The film thickness of the organic film layer (B) is preferably 5 to 50 nm, more preferably 10 to 40 nm. When the film thickness is 100 nm, an interference fringe of visible light generates, and the existence of a coating film (the organic film layer (B)) can be recognized by visual inspection. In this case, it is possible to check the organic film layer (B) visually under visible light without using the inventive wafer processing laminate. When the film thickness is less than 100 nm, however, the interference fringe becomes thinner, and hard to check by visual inspection. Particularly, when the film thickness is 5 to 50 nm, the visual inspection becomes difficult, and it is more favorable to use the inventive wafer processing laminate.

The component in the organic film layer (B) other than the fluorescent agent is not particularly limited. It is preferable not to contain solid contents with a size larger than the film thickness to be formed.

As for the component in the organic film layer (B) other than the fluorescent agent, a thermoplastic organopolysiloxane polymer can be used. The thermoplastic organopolysiloxane polymer has low glass transition temperature and fluidity at the normal temperature. Accordingly, this cannot always be observed by a method in which the cross section of a wafer is observed to measure the coating thickness. Therefore, the inventive wafer processing laminate can be used more favorably.

As the thermoplastic organopolysiloxane polymer contained in the organic film layer (B), the structure is not particularly limited. Illustrative examples thereof include a non-reactive organopolysiloxane that contains 99.000 to 99.999 mol% of a siloxane unit represented by R¹¹R¹²SiO_{2/2} (D unit), 1.000 to 0.001 mol% of a siloxane unit represented by R¹³R¹⁴R¹⁵SiO_{1/2} (M unit), and 0.000 to 0.500 mol% of a siloxane unit represented by R¹⁶SiO_{3/2} (T unit), having a weight average molecular weight of 200,000 to 1,000,000, in which a low molecular weight component having a molecular weight of 740 or less is 0.5% by mass or less, for example.

In the foregoing formulae, the organic substituents R¹¹, R¹², R¹³, R¹⁴, R¹⁵, and R¹⁶ each independently represent an unsubstituted or substituted monovalent hydrocarbon group, preferably an unsubstituted or substituted monovalent hydrocarbon group having 1 to 10 carbon atoms. Illustrative examples thereof include hydrocarbon groups, for example, alkyl groups such as a methyl group, an ethyl group, a n-propyl group, an isopropyl group, a n-butyl group, a t-butyl group, a n-pentyl group, a cyclopentyl group, and a n-hexyl group, cycloalkyl groups such as a cyclohexyl group, aryl groups such as a phenyl group and a tolyl group; and their halogenated groups in which part of or all of the hydrogen atom(s) are substituted with halogen atom(s). In these groups, a methyl group and a phenyl group are commonly used.

It is preferable that the organopolysiloxane has a weight average molecular weight that is measured by gel permeation chromatography (GPC) in accordance with a calibration curve in terms of polystyrene standard (in this description, "weight average molecular weight" means this value) of 200,000 or more, particularly 350,000 or more, and 1,000,000 or less, particularly 800,000 or less, with the proviso that the content of the low molecular weight component having a molecular weight of 740 or less is 0.5% by mass or less.

The thermoplastic organopolysiloxane polymer contained in the organic film layer (B) may also be a condensate in which a organopolysiloxane resin having a R²¹R²²R²³SiO_{1/2} unit and a SiO_{4/2} unit in a molar ratio of 0.6 to 1.7 is partly condensed with organopolysiloxane shown by the following general formula (1) with the both terminals being blocked by hydroxy groups and having a polymerization degree (n) of 5000 to 10000. Since the organopolysiloxane has a polymerization degree of 5000 to 10000, the organic film layer (B) that contains the foregoing condensate can be a layer of highly polymerized thermoplastic polymer of resin modified organosiloxane.

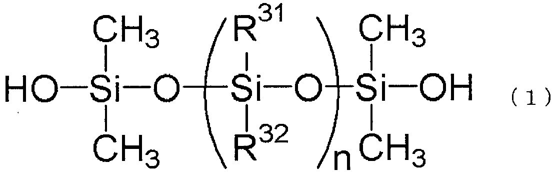

In the formula, R³¹ and R³² each independently represent an unsubstituted or substituted monovalent hydrocarbon group having 1 to 10 carbon atoms, specifically a monovalent hydrocarbon group including alkyl groups such as a methyl group, an ethyl group, a n-propyl group, an isopropyl group, a n-butyl group, a t-butyl group, a n-pentyl group, a cyclopentyl group, and a n-hexyl group, cycloalkyl groups such as a cyclohexyl group, aryl groups such as a phenyl group and a tolyl group; and their halogenated groups in which part of or all of the hydrogen atom(s) are substituted with halogen atom(s). In these groups, a methyl group and a phenyl group are commonly used.

In the formula, R²¹, R²² and R²³ each independently represent an unsubstituted or substituted monovalent hydrocarbon group having 1 to 10 carbon atoms or a hydroxy group, specifically a monovalent hydrocarbon group including alkyl groups such as a methyl group, an ethyl group, a n-propyl group, an isopropyl group, a n-butyl group, a t-butyl group, a n-pentyl group, a cyclopentyl group, and a n-hexyl group, cycloalkyl groups such as a cyclohexyl group, aryl groups such as a phenyl group and a tolyl group; and their halogenated groups in which part of or all of the hydrogen atom(s) are substituted with halogen atom(s), as well as a hydroxy group. In these groups, a methyl group is commonly used.

The organopolysiloxane resin having an R²¹R²²R²³SiO_{1/2} unit (M unit) and a SiO_{4/2} unit (Q unit) (hereinafter, also referred to as a MQ resin) may contain a hydroxy group bonded to a silicon atom. The content of the hydroxy group per 100 g of a MQ resin is about 0 to 4.0% by mass. This MQ resin may contain relatively small amount of an R²⁴SiO_{3/2} unit (T unit) and an R²⁵R²⁶SiO_{2/2} unit (D unit) . In this formula, R²⁴, R²⁵, and R²⁶ each independently represent an unsubstituted or substituted monovalent hydrocarbon group having 1 to 10 carbon atoms or a hydroxy group, and specific examples thereof include the same groups in the foregoing examples of R²¹, R²², and R²³.

In the thermoplastic resin modified organopolysiloxane, the organopolysiloxane and the organopolysiloxane resin are subjected to dehydration condensation generally in a ratio of 99:1 to 50:50.

The dehydration condensation reaction may be carried out in a solvent such as pentane, hexane, cyclopentane, cyclohexane, methylcyclohexane, octane, isooctane, decane, undecane, isododecane, limonene, pinene, and toluene; generally toluene. This reaction may also be performed in the presence of an amine-type catalyst such as aqueous ammonia, triethylamine, and pyridine; generally aqueous ammonia. The reaction time is preferably 12 to 100 hours.

In the organopolysiloxane obtained after the reaction, the remained hydroxy group(s) may be converted to a trimethylsiloxy group(s) by dissolving the obtained organopolysiloxane into a solvent such as toluene, adding 5 to 20 parts by mass of hexamethylsilazane to 100 parts by mass of the organopolysiloxane, and refluxing the mixture for 3 to 5 hours.

The obtained resin modified organopolysiloxane may also be dissolved and precipitated in such a way that the obtained organopolysiloxane is dissolved into a good solvent such as hexane, and mixed with 1.5 to 3 times of the total amount of a poor solvent such as acetone. It is also possible to use this resin modified organopolysiloxane precipitated as an under layer.

The obtained resin modified organopolysiloxane generally has a weight average molecular weight of 400,000 or more in terms of a value measured by gel permeation chromatography (GPC) in accordance with a calibration curve with polystyrene standard.

The method for forming the organic film layer (B) is not particularly limited. The method includes spin-coating, slit coating, spray coating, vacuum deposition, and film laminating. For example, when spin-coating method is used, a spin-coating film is formed as the organic film layer (B).

Particularly in spin-coating, it is general to condition the organic film layer (B) prior to the use, by dissolving the component(s) into a solvent and so on so that the targeted film thickness can be coated. In this case, the mixture of the component(s) of the organic film layer (B) and the solvent may be spin-coated while controlling the liquid amount so as to give a desired thickness. In case of using a 200 mm wafer, it is preferable to control the coating amount (dropping amount) of the mixture to 0.5 to 20 ml. The solvent is not particularly limited as far as the solvent can dissolve the organic film layer (B). For example, when the foregoing thermoplastic organopolysiloxane polymer is used as the organic film layer (B), it is favorable to use a hydrocarbon solvent such as pentane, hexane, cyclohexane, isononane, decane, isododecane, limonene, and p-menthane.

When the thermoplastic organopolysiloxane polymer is dissolved into a solvent, the polymer concentration in the solution is 0.01 to 3.00% by mass, preferably 0.05 to 2.00% by mass, more preferably 0.20 to 1.00% by mass. When the concentration of the solution is 0.01% by mass or more, the applied film is prevented from being too thin, and the film formation becomes easier. When the concentration of the solution is 3.00% by mass or less, the film thickness is prevented from exceeding 100 nm after applying the film. The organic film layer (B) can be formed by additionally dissolving a fluorescent agent into this solution in which thermoplastic organopolysiloxane polymer is dissolved into a solvent, followed by spin-coating.

In case of the organic film layer (B) described above, the present invention makes it possible to conveniently observe the distribution state in a wafer surface by nondestructive process using visual inspection or observation through microscope.

### [Fluorescent Agent]

The fluorescent agent is not particularly limited as far as it is fluorescent material that emits visible light by irradiation with ultraviolet light. It is preferable that the wavelength of the ultraviolet light to be applied be in a range of 200 to 400 nm, particularly 300 to 400 nm; and the emitted visible light have a wavelength in a range of 380 to 750 nm, particularly 400 to 500 nm.

Fluorescent whitening agents are known to fulfill the foregoing wavelengths of light absorption and emission, and are preferably used as the fluorescent agent since they are easy to procure and have lower risk.

The fluorescent whitening agent may include the following examples.

Distyrylbenzenes such as 1,4-distyrylbenzene and 4,4'-bis(2-methoxystyryl)biphenyl each having a cyano group(s); distyrylbiphenyls such as disodium salt of 4,4'-di(2-sulfostyryl)biphenyl, disodium salt of 4,4'-di(3-sulfostyryl)biphenyl, disodium salt of 4,4'-di(4-chloro-3-sulfostyryl)biphenyl, and disodium salt of 4,4'-di(6-chloro-3-sulfostyryl)biphenyl; divinylstilbenes such as 4,4'-di(ethoxycarbonylvinyl)stilbene and 4,4'-di(cyanovinyl)stilbene; triazinylaminostilbenes such as 1,3,5-triazinyl derivative of 4,4'-diaminostilbene-2,2'-disulfonic acid; stilbenyl-2H-triazoles such as stilbenyl-2H-naphtho[1,2-d]triazole and bis(1,2,3-triazol-2-yl)stilbene; benzoxazoles such as stilbenylbenzoxazole, bis(benzoxazole), and 1,4-bis(2-benzoxazolyl)naphthalene; furans; benzofurans; benzoimidazoles; coumarins. The fluorescent whitening agent is preferably distyrylbenzenes and benzoxazoles. The foregoing fluorescent whitening agent makes it easier to check the coating situation by the emission.

The content of the fluorescent agent in the organic film layer (B) is generally 0.1 to 50% by mass, preferably 1.0 to 30% by mass, more preferably 2.0 to 20% by mass. When the amount is 0.1% by mass or more, the emission can be recognized easily; and when the amount is 50% by mass or less, the film thickness becomes hard to variate.

### [Method for Manufacturing a Wafer Processing Laminate]

The inventive method for manufacturing a wafer processing laminate is a method including the step of forming an organic film layer (B) with a film thickness of less than 100 nm onto a wafer having a surface on which unevenness and/or a protective organic film layer (A) is formed, and is characterized in that: the organic film layer (B) comprises a fluorescent agent that emits visible light by irradiation with ultraviolet light.

The specifics of the structure of each organic film layer and the methods for forming the organic film layer (B) are the same as described in the items of the wafer processing laminate.

Such a method for manufacturing a wafer processing laminate makes it possible to securely produce a wafer processing laminate in which the coverage of the organic film can be checked by a nondestructive and convenient method that can reuse the wafer.

After the step of forming, it is preferable to perform the step of subjecting the wafer having the organic film layer (B) formed thereon to irradiation with ultraviolet light to check the coverage of the organic film layer (B) by an emission state in the irradiation. Such a checking step makes it convenient to check a portion(s) where the organic film layer (B) is not formed.

In the present invention, it is also possible to manufacture a thin film wafer by forming a layer of the third component such as a self-adhesive and an adhesive onto a wafer on which the organic film layer (B) is formed, further forming a support on the layer of the third component in accordance with needs, and subjecting the wafer surface that is not laminated (the back surface) to grinding process, etc. In this case, it is possible to use a wafer processing laminate in which the coverage of the organic film layer (B) is recognized as good by the foregoing checking step. It is also possible to use a wafer processing laminate manufactured under the same conditions as for the wafer processing laminate, the coverage of which is recognized as good, except that a fluorescent agent is not contained.

### [Method for Checking Coverage of Organic Film]

The inventive method for checking coverage of an organic film is a method for checking coverage of an organic film layer (B) with a film thickness of less than 100 nm, being formed on a wafer having a surface on which unevenness and/or a protective organic film layer (A) is formed, characterized in that:
the organic film layer (B) comprises a fluorescent agent that emits visible light by irradiation with ultraviolet light, and
the wafer having the organic film layer (B) formed thereon is subjected to irradiation with ultraviolet light to check the coverage of the organic film layer (B) by an emission state in the irradiation.

The specifics of the structure of each organic film layer and the methods for forming the organic film layer (B) are the same as described in the items of the wafer processing laminate.

In the inventive method for checking coverage of an organic film, the organic film layer (B) contains a fluorescent agent that emits visible light by irradiation with ultraviolet light. Accordingly, by irradiating the wafer on which the organic film layer (B) formed thereon with ultraviolet light, it is possible to check the coverage of the organic film layer (B) on the basis of the emission state in the irradiation. Specifically, the portion where an organic film layer (B) is not formed does not emit, and accordingly, it is possible to judge the portion without emission as a portion where an organic film layer (B) is not formed. This makes it possible to specifically check the distribution state of an organic film on a wafer having pattern such as unevenness and so on by visual inspection, etc. It is also possible to determine coating conditions to give good coverage.

As an example of the application, for example, this wafer processing laminate can be applied to a technology of temporary adhering a wafer to give a thinned wafer processing laminate in which this wafer processing laminate is adhered to a support on the side of the organic film layer (B) via an adhesive layer to form a wafer laminate, the backside of the wafer processing laminate is mechanically polished to thin the wafer processing laminate, and the thinned wafer processing laminate is delaminated from the wafer laminate by using the organic film layer (B) as a delaminating layer. In this case, any material can be applied to the adhesive layer as far as it can closely fill the fine unevenness on the surface of a wafer processing laminate without damaging the device surface of the wafer processing laminate. It is preferable to use thermosetting resin or thermoplastic resin, particularly uncured thermosetting resin. It is to be noted that the application of the wafer processing laminate is not limited to the above.

### EXAMPLES

Hereinafter, the present invention will be described more specifically by showing Examples and Comparative Examples, but the present invention is not limited to the following Examples.

### [Synthesis Example of Resin]

Into a four-neck flask, 1,000 g (3.38 mol) of octamethylcyclotetrasiloxane and 0.24 g (0.0015 mol) of hexamethyldisiloxane were introduced, and the temperature was maintained at 110°C. Then, 4 g of 10% by mass tetrabutylphosphonium hydroxide siliconate was added to the mixture. After polymerization over 4 hours, a posttreatment was carried out at 160°C for 2 hours to give dimethylpolysiloxane.

This dimethylpolysiloxane was analyzed by ²⁹Si-NMR method to determine the ratio of D unit and M unit. This was identified to be a dimethylpolysiloxane having the following structure containing 99.978% of D unit and 0.022% of M unit with the polymerization degree of about 9,000.

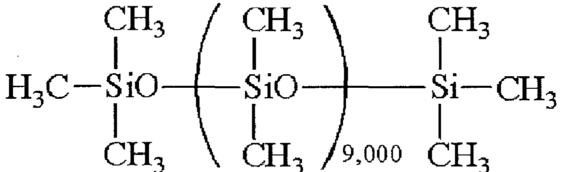

Into 500 g of hexane, 500 g of this dimethylpolysiloxane was dissolved. Then, this was introduced into 2 L of acetone, and the precipitated resin was collected. Thereafter, hexane and so on were removed under vacuum to give a dimethylpolysiloxane polymer having a weight average molecular weight of 700,000, and containing 0.05% by mass of a low molecular weight component having a molecular weight of 740 or less. Into 99.5 g of isododecane, 0.5 g of this polymer was dissolved to give an isododecane solution (b1) of the dimethylpolysiloxane polymer. Into 99.7 g of isododecane, 0.3 g of this polymer was dissolved to give an isododecane solution (b2). Into 99.0 g of isododecane, 1.0 g of this polymer was dissolved to give an isododecane solution (b3). Incidentally, the weight average molecular weight was measured by GPC.

### [Examples 1 to 8, Comparative Examples 1 and 2]

Into the (b1), (b2), or (b3) solution, the fluorescent whitening agent (c1) or (c2) was added in accordance with Table 1. Each of them was stirred to be mixed, and filtered through a 0.2 µm of membrane filter to give (B-1), (B-2), (B-3), (B-4), (B-6), and (B-7) solutions. It is to be noted that the (B-5) solution was prepared by filtering the (b1) solution through a 0.2 µm of membrane filter without adding a fluorescent whitening agent.

Each of these solutions was applied by spin-coating onto a silicon wafer with a diameter of 200 mm (thickness: 725 µm) having a surface on which copper posts each having a height of 10 µm and a diameter of 20 µm were formed entirely, and which surface also had a polyimide film with the thickness of 8 µm as the protective organic film layer (A) formed only at the portion without copper posts. This was heated on a hot plate at 180°C for 5 minutes to form a film of a material corresponding to the organic film layer (B) with a film thickness shown in Table 1 onto the surface on which the wafer posts and the protective organic film layer (A) were formed (see FIG. 1). Incidentally, the film thicknesses in Table 1 are measured values obtained as follows. That is, as shown in FIG. 2, each of these values was obtained by using an optical interference type film thickness measuring apparatus, and by measuring the film thickness of a material obtained by applying each of the foregoing solutions, which corresponds to the organic film layer (B) 23, onto the bare Si wafer 21 with a diameter of 200 mm under the same coating conditions as in the silicon wafer on which copper posts and so on were formed.

Subsequently, the foregoing wafers were irradiated with black light with the wavelength of 325 nm in a darkroom to check each emission state.

**[Table 1]**

| | | Examples | | | | | | | | Comparative Examples | |
|---|---|---|---|---|---|---|---|---|---|---|---|
| | | 1 | 2 | 3 | 4 | 5 | 6 | 7 | 8 | 1 | 2 |
| | (b) Solution* | (b1) 100 | (b1) 100 | (b1) 100 | (b1) 100 | (b2) 100 | (b3) 100 | (b1) 100 | (b1) 100 | (b1) 100 | (b1) 100 |
| Production Conditions | Polymer amount in (b) solution* | 0.5 | 0.5 | 0.5 | 0.5 | 0.3 | 1.0 | 0.5 | 0.5 | 0.5 | 0.5 |
| | Fluorescent whitening agent* | (c1) 0.05 | (c1) 0.05 | (c2) 0.05 | (c2) 0.05 | (c1) 0.03 | (c1) 0.1 | (c1) 0.02 | (c1) 0.10 | - | - |
| | Fluorescent whitening agent in applied (B) layer (mass%) | 9.1% | 9.1% | 9.1% | 9.1% | 9.1% | 9.1% | 3.8% | 16.7% | - | - |
| | (B) Solution | (B-1) | (B-1) | (B-2) | (B-2) | (B-3) | (B-4) | (B-6) | (B-7) | (B-5) | (B-5) |
| | Dropping amount/spin-coating | 10 ml | 2 ml | 10 ml | 2 ml | 10 ml | 10 ml | 10 ml | 10 ml | 10 ml | 2 ml |
| | Thickness of (B) laver | 25 nm | 25 nm | 25 nm | 25 nm | 15 nm | 40 nm | 23 nm | 28 nm | 22 nm | 22 nm |
| Results | Emission recognition | Recognized | Recognized | Recognized | Recognized | Recognized | Recognized | Recognized | Recognized | Failed | Failed |
| | Coating failure | Coated entirely | Coating failure at periphery | Coated entirely | Coating failure at periphery | Coated entirelv | Coated entirely | Coated entirely | Coated entirely | Failed to check | Failed to check |

| | | | | | | | | | | | |
|---|---|---|---|---|---|---|---|---|---|---|---|
| * unit: parts by mass (c1): 4,4'-bis(2-methoxystyryl)biphenyl (c2): 1,4-bis(2-benzoxazolyl)naphthalene | | | | | | | | | | | |

As shown in Table 1, in Examples 1 to 8, which satisfied the requirements of the present invention, it was possible to recognize the emission (visible light) on each surface coated with the organic film layer (B) to visually check the formation of the organic film layer (B) by irradiating black light. On the other hand, in Comparative Examples 1 and 2, film formation could not be checked by visual inspection, since a fluorescent agent was not contained. In Examples 1, 3, 5, 6, 7, and 8, it was possible to visually recognize that each wafer could be entirely coated without coating failure since coating was performed with dropping sufficient amount of solution required for coating. In Examples 2 and 4, it was possible to recognize that coating failure had formed on each periphery, as a result of coating with intentionally decreasing the dropping amount, by visual inspection on the basis of emission. On the other hand, in Comparative Examples 1 and 2, emission could not be recognized, whereby it was impossible to check the existence or nonexistence of coating failure.

It is to be noted that the present invention is not restricted to the foregoing embodiment. The embodiment is just an exemplification, and any examples that have substantially the same feature and demonstrate the same functions and effects as those in the technical concept described in claims of the present invention are included in the technical scope of the present invention The invention is defined by the appended claims.

## Claims

1. A wafer processing laminate comprising :
a wafer (11) having a surface on which unevenness and/or a protective organic film layer A (12) is formed, and
an organic film layer B (13) with a film thickness of less than 100 nm which is formed on the wafer (11) and the unevenness and/or protective organic film layer A (12),
the organic film layer B (13) comprising a fluorescent agent that emits visible light by irradiation with ultraviolet light,
10 wherein the wafer (11) having a surface on which said unevenness and/or protective organic film layer A (12) is formed is a device wafer having a circuit formed.

2. The wafer processing laminate according to claim 1, wherein the organic film layer B (13) with a film thickness of less than 100 nm is a spin-coated film.

3. The wafer processing laminate according to claim 1 or 2, wherein the organic film layer B (13) has a film thickness of 5 to 50 nm.

4. The wafer processing laminate according to any one of claims 1 to 3, wherein 20 the organic film layer B (13) comprises a thermoplastic organopolysiloxane polymer as a component other than the fluorescent agent.

5. The wafer processing laminate according to any one of claims 1 to 4, wherein the fluorescent agent is a fluorescent whitening agent.

6. A method for checking coverage of an organic film layer B (13) being formed on a wafer (11) having a surface on which unevenness and/or a protective organic film layer A (12) is formed, **characterized in that** the organic film layer B (13) has a film thickness of less than 100 nm,
30 the wafer (11) having a surface on which the unevenness and/or protective organic film layer A (12) is formed is a device wafer having a circuit formed, the organic film layer B (13) comprises a fluorescent agent that emits visible light by irradiation with ultraviolet light, and the wafer (11) having the organic film layer B (13) (B) formed thereon is subjected to 35 irradiation with ultraviolet light to check the coverage of the organic film layer B (13) by an emission state in the irradiation.

7. A method for manufacturing a wafer processing laminate, including the step of forming an organic film layer B (13) onto a wafer (11) having a surface on which unevenness and/or a protective organic film layer A (12) is formed, **characterized in that** the organic film layer B (13) has a film thickness of less than 100 nm,
the wafer (11) having a surface on which the unevenness and/or protective organic film layer A (12) is formed is a device wafer having a circuit formed, and the organic film layer B (13) comprises a fluorescent agent that emits visible light by irradiation with ultraviolet light.

8. The method for manufacturing a wafer processing laminate according to claim 7, further comprising the step of subjecting the wafer having the organic film layer B(13) formed thereon to irradiation with ultraviolet light after the step of forming to check the coverage of the organic film layer B (13) by an emission state in the irradiation.

## Patentansprüche

1. Wafer-Verarbeitungslaminat, umfassend:
einen Wafer (11) mit einer Oberfläche, auf der Unebenheiten und/oder eine schützende organische Filmschicht A (12) ausgebildet sind, und eine organische Filmschicht B (13) mit einer Filmdicke von weniger als 100 nm, die auf dem Wafer (11) und der Unebenheit und/oder der schützenden organischen Filmschicht A (12) ausgebildet ist,
wobei die organische Filmschicht B (13) ein fluoreszierendes Mittel umfasst, das durch Bestrahlung mit ultraviolettem Licht sichtbares Licht emittiert,
wobei der Wafer (11) mit einer Oberfläche, auf der die Unebenheit und/oder die schützende organische Filmschicht A ausgebildet ist, ein Vorrichtungswafer ist, auf dem eine Schaltung ausgebildet ist.

2. Wafer-Verarbeitungslaminat nach Anspruch 1, wobei die organische Filmschicht B (13) mit einer Filmdicke von weniger als 100 nm ein schleuderbeschichteter Film ist.

3. Wafer-Verarbeitungslaminat nach Anspruch 1 oder 2, wobei die organische Filmschicht B (13) eine Filmdicke von 5 bis 50 nm aufweist.

4. Wafer-Verarbeitungslaminat nach einem der Ansprüche 1 bis 3, wobei die organische Filmschicht B (13) ein thermoplastisches Organopolysiloxanpolymer als eine andere Komponente als das Fluoreszenzmittel umfasst.

5. Wafer-Verarbeitungslaminat nach einem der Ansprüche 1 bis 4, wobei das fluoreszierende Mittel ein fluoreszierendes Aufhellungsmittel ist.

6. Verfahren zum Überprüfen der Bedeckung einer organischen Filmschicht B (13), die auf einem Wafer (11) gebildet wird, der eine Oberfläche aufweist, auf der Unebenheiten und/oder eine schützende organische Filmschicht A (12) gebildet sind, **dadurch gekennzeichnet, dass**:
die organische Filmschicht B (13) eine Filmdicke von weniger als 100 nm hat,
der Wafer (11) mit einer Oberfläche, auf der die Unebenheit und/oder eine schützende organische Filmschicht A (12) ausgebildet ist, ein Vorrichtungswafer ist, auf dem eine Schaltung ausgebildet ist,
die organische Filmschicht B (13) ein fluoreszierendes Mittel umfasst, das durch Bestrahlung mit ultraviolettem Licht sichtbares Licht emittiert, und
der Wafer (11) mit der darauf ausgebildeten organischen Filmschicht B (13) einer Bestrahlung mit ultraviolettem Licht unterzogen wird, um die Bedeckung der organischen Filmschicht B (13) durch einen Emissionszustand bei der Bestrahlung zu überprüfen.

7. Verfahren zum Herstellen eines Wafer-Verarbeitungslaminats, das den Schritt des Ausbildens einer organischen Filmschicht B (13) auf einem Wafer (11) mit einer Oberfläche, auf der Unebenheiten und/oder eine schützende organische Filmschicht A (12) ausgebildet sind, umfasst, **dadurch gekennzeichnet, dass**:
die organische Filmschicht B (13) eine Filmdicke von weniger als 100 nm hat,
der Wafer (11) mit einer Oberfläche, auf der die Unebenheit und/oder die schützende organische Filmschicht A (12) ausgebildet ist, ein Vorrichtungswafer ist, auf dem eine Schaltung ausgebildet ist, und
die organische Filmschicht B (13) einen fluoreszierenden Wirkstoff enthält, der bei Bestrahlung mit ultraviolettem Licht sichtbares Licht emittiert.

8. Verfahren zur Herstellung eines Wafer-Verarbeitungslaminats nach Anspruch 7, das ferner den Schritt umfasst, den Wafer mit der darauf gebildeten organischen Filmschicht B (13) nach dem Schritt der Bildung, einer Bestrahlung mit ultraviolettem Licht zu unterziehen, um die Bedeckung der organischen Filmschicht B (13) durch einen Emissionszustand bei der Bestrahlung zu überprüfen.

## Revendications

1. Stratifié de traitement de plaquette comprenant:
une plaquette (11) ayant une surface sur laquelle est formée une couche de film organique irrégulier et/ou protecteur A (12), et une couche de film organique B (13) avec une épaisseur de film inférieure à 100 nm qui est formée sur la plaquette (11) et la couche de film organique irrégulier et/ou protecteur A (12),
la couche de film organique B (13) comprenant un agent fluorescent qui émet de la lumière visible par irradiation avec de la lumière ultraviolette,
dans lequel la plaquette (11) ayant une surface sur laquelle est formée ladite couche de film organique irrégulier et/ou protecteur A (12) est une plaquette de dispositif ayant un circuit formé.

2. Stratifié de traitement de plaquette selon la revendication 1, dans lequel la couche de film organique B (13) avec une épaisseur de film inférieure à 100 nm est un film appliqué par centrifugation.

3. Stratifié de traitement de plaquette selon la revendication 1 ou 2, dans lequel la couche de film organique B (13) a une épaisseur de film de 5 à 50 nm.

4. Stratifié de traitement de plaquette selon l'une quelconque des revendications 1 à 3, dans lequel la couche de film organique B (13) comprend un polymère organopolysiloxane thermoplastique en tant que constituant autre que l'agent fluorescent.

5. Stratifié de traitement de plaquette selon l'une quelconque des revendications 1 à 4, dans lequel l'agent fluorescent est un agent de blanchiment fluorescent.

6. Procédé pour vérifier la couverture d'une couche de film organique B (13) étant formée sur une plaquette (11) ayant une surface sur laquelle est formée une couche de film organique irrégulier et/ou protecteur A (12), **caractérisé en ce que** la couche de film organique B (13) a une épaisseur de film inférieure à 100 nm, la plaquette (11) ayant une surface sur laquelle est formée la couche de film organique irrégulier et/ou protecteur A (12) est une plaquette de dispositif ayant un circuit formé,
la couche de film organique B (13) comprend un agent fluorescent qui émet de la lumière visible par irradiation avec de la lumière ultraviolette, et
la plaquette (11) sur laquelle est formée la couche de film organique B (13) est soumise à une irradiation avec une lumière ultraviolette pour vérifier la couverture de la couche de film organique B (13) par un état d'émission lors de l'irradiation.

7. Procédé de fabrication d'un stratifié de traitement de plaquette, comprenant l'étape de formation d'une couche de film organique B (13) sur une plaquette (11) ayant une surface sur laquelle est formée une couche de film organique irrégulier et/ou protecteur A (12), **caractérisé en ce que** la couche de film organique B (13) a une épaisseur de film inférieure à 100 nm,
la plaquette (11) ayant une surface sur laquelle est formée la couche de film organique irrégulier et/ou protecteur A (12) est une plaquette de dispositif ayant un circuit formé, et
la couche de film organique B (13) comprend un agent fluorescent qui émet de la lumière visible par irradiation avec une lumière ultraviolette.

8. Procédé de fabrication d'un stratifié de traitement de plaquette selon la revendication 7, comprenant en outre l'étape de soumission de la plaquette sur laquelle est formée la couche de film organique B (13) à une irradiation avec de la lumière ultraviolette après l'étape de formation pour vérifier la couverture de la couche de film organique B (13) par un état d'émission lors de l'irradiation.
